Europäisches Patentamt

European Patent Office

Office européen des brevets

(11) Numéro de publication: **0 337 826**
**A1**

## (12) DEMANDE DE BREVET EUROPEEN

(21) Numéro de dépôt: **89400633.7**

(22) Date de dépôt: **07.03.89**

(51) Int. Cl.⁴: **G 01 T 1/00**
H 01 L 27/14, H 01 L 31/10

(30) Priorité: **11.03.88 FR 8803227**

(43) Date de publication de la demande:
**18.10.89 Bulletin 89/42**

(84) Etats contractants désignés: **DE FR GB NL**

(71) Demandeur: **THOMSON-CSF**
**51, Esplanade du Général de Gaulle**
**F-92800 Puteaux (FR)**

(72) Inventeur: **Guyot, Lucien THOMSON-CSF**
**SCPI 51, Esplanade du Général de Gaulle**
**Cédex 67 F-92045 Paris la Défense (FR)**

(74) Mandataire: **Guérin, Michel et al**
**THOMSON-CSF SCPI 51, Esplanade du Général de**
**Gaulle**
**F-92045 PARIS LA DEFENSE CEDEX 67 (FR)**

(54) **Dispositif d'imagerie à structure matricielle.**

(57) L'invention concerne un dispositif d'imagerie (10) du type notamment associant un écran scintillateur (11) et une matrice (1) d'éléments photosensibles (D). L'invention concerne particulièrement des moyens permettant de réduire beaucoup plus une surface active (Sa) d'un élément photosensible (D), que la quantité de lumière à laquelle cet élément photosensible (D) est exposé.

A cette fin, le scintillateur (11) comporte un écran d'entrée (20) et un écran de sortie (15) appliqués respectivement sur une face d'entrée (21) et une face de sortie (16) du scintillateur (11), l'écran de sortie (11) étant muni d'ouverture (18) laissant passer une lumière émise par le scintillateur (11), les ouvertures (18) étant disposées selon un arrangement matriciel et indexées sur le réseau d'éléments photosensibles (D).

FIG. 2

EP 0 337 826 A1

**Description**

## DISPOSITIF D'IMAGERIE A STRUCTURE MATRICIELLE

La présente invention concerne un dispositif d'imagerie du type par exemple associant un écran scintillateur et une matrice d'éléments photosensibles, et permettant notamment la conversion d'une image radiologique en signaux électriques. L'invention concerne particulièrement des moyens pour améliorer le rapport signal/bruit lors de la lecture de signaux délivrés par les éléments photosensibles.

De manière classique, les matrices photosensibles comportent un réseau de conducteur en ligne et un réseau de conducteur en colonne. A chaque croisement d'un conducteur ligne et d'un conducteur colonne, est disposé un montage photosensible appelé point photosensible dans la suite de la description. Les points photosensibles sont ainsi organisés également en ligne et en colonne. Chaque point photosensible est connecté entre un conducteur ligne et un conducteur colonne : en fait, à chaque conducteur ligne sont connectés autant de points photosensibles qu'il y a de colonnes de ces derniers, et à chaque conducteur en colonne sont connectés autant de points photosensibles qu'il y a de lignes de ces derniers.

Le nombre de points photosensibles dans une surface donnée, détermine la résolution de l'image. Il est connu de réaliser des matrices d'éléments photosensibles de grande capacité, par exemple 2000 x 2000 points photosensibles, pour obtenir une image dont les dimensions sont de l'ordre de 40 cm x 40 cm. Dans ce cas, chaque point photosensible est situé dans une zone ou surface élémentaire dont les dimensions maximum sont de 200 micromètres x 200 micromètres.

Chaque point photosensible comporte un élément photosensible tels que photodiode, phototransistor, photoconducteur, sensible aux photons lumineux visibles. Ces photons lumineux sont convertis en charge électrique, et cette charge électrique est accumulée dans une capacité électrique formant une capacité de stockage, constituée soit par la capacité de l'élément photosensible lui-même, ou par une capacité annexe associée. Un dispositif de lecture permet d'interroger l'état électrique de la capacité de stockage, et de convoyer la charge électrique qui constitue le signal vers un amplificateur de signal.

Un exemple de matrice photosensible est donné dans un brevet français n° 86 00656 publié sous le n° 2.579.319. qui décrit le fonctionnement détaillé d'une matrice photosensible ainsi que le procédé de lecture approprié, chaque point photosensible de cette matrice étant constitué par une photodiode en série avec une capacité.

Un autre brevet français n° 86 00716 publié sous le n° 2593343 se rapporte à une matrice ayant un réseau de points photosensibles constitués chacun par une photodiode et une capacité en série, comme ci-dessus mentionné, et ce brevet décrit un procédé de fabrication d'une telle matrice photosensible, ainsi qu'un procédé de lecture de cette matrice et une application de cette matrice à la prise de vue d'image radiologique. Un des avantages du type de structure décrite dans ce brevet, est de permettre la réalisation de matrice de grande dimension et donc applicable de manière avantageuse à la radiologie, en utilisant les dépôts en couche mince de semiconducteurs, de silicium amorphe notamment. Dans ce brevet, en vue de capter des images radiologiques, la structure présentée comporte un écran ou panneau scintillateur qui est soumis à un rayonnement X. En réponse à ce rayonnement X, l'écran scintillateur émet un rayonnement en lumière visible auquel sont sensibles les photodiodes.

Cependant, l'un des problèmes principaux que pose la lecture des points photosensibles, quelle que soit la manière dont ceux-ci sont constitués et qu'il s'agisse d'une image radiologique ou non, réside dans une trop forte valeur de la capacité électrique présentée par les éléments photosensibles. L'influence de cette capacité s'exerce particulièrement lors de la lecture des points photosensibles, c'est-à-dire lors de l'amplification de la photocharge développée par un élément photosensible suite à son éclairement, et cette capacité des éléments photosensibles a pour effet de réduire le rapport signal/bruit.

En effet, en prenant pour exemple un point photosensible dont la structure est celle décrite dans les deux brevets ci-dessus cités : un point photosensible est constitué par une photodiode $D_0$ placée en série avec une capacité $C_0$. La photodiode $D_0$ est reliée à un conducteur en ligne donné $H_0$, et la capacité $C_0$ est reliée à un conducteur en colonne $V_0$ donné. L'ensemble des autres points photosensibles, reliés sur cette même colonne $V_0$, à une capacité équivalente $C_{eq}$.

La photodiode $D_0$, initialement polarisée en inverse par un signal approprié appliqué sur la ligne $H_0$, est éclairée par un flux lumineux émis par un scintillateur. Par application d'un signal électrique approprié sur la ligne $H_0$, on restitue le potentiel d'un point A (situé à la jonction de la photodiode D et de la capacité C et où est accumulée la photocharge) à son niveau de polarisation initiale : il en résulte la circulation dans la colonne $V_0$ d'une charge électrique $q_0$ de lecture proportionnelle à la photocharge, qui donne naissance à une tension signal vs aux bornes de la capacité $C_{eq}$ de cette colonne.

On montre aisément que cette tension signal vs est égale à : $vs = q_0/N.CD$ ; où $q_0$ représente la photocharge développée au sein de la diode $D_0$, N est le nombre de points photosensibles disposés selon la colonne, CD et la capacité de la photodiode.

La tension de signal vs est amplifiée dans un amplificateur G qui est, soit associé directement à la colonne $V_0$, ou bien associé à plusieurs colonnes par l'intermédiaire d'un dispositif multiplexeur.

Comme il a été précédemment mentionné, une caractéristique importante est le rapport signal/bruit S/B, qui est lié à la capacité CD des éléments photosensibles par la relation suivante :

$$S/B = \frac{qo}{N \cdot CD} \times \frac{1}{vb}$$

où vb est la tension de bruit à l'entrée de l'amplificateur.

Cette relation montre que le rapport S/B est optimisé lorsque le facteur N.CD est minimisé, c'est-à-dire lorsque pour un nombre d'éléments photosensibles N disposés sur une colonne donnée, la capacité de l'élément photosensible est la plus faible possible.

Dans la configuration la plus classique, la capacité de l'élément photosensible, d'une photodiode par exemple, est liée d'une part, à l'épaisseur du matériau (silicium intrinsèque, épaisseur limitée à quelques micromètres), et elle est liée d'autre part à la surface active ou section de la diode photosensible qui est soumise aux photons lumineux, et qui est appelée "surface active", cette surface étant pratiquement délimitée par les surfaces des électrodes croisées en regard, c'est-à-dire par les surfaces d'intersection entre les conducteurs en ligne et les conducteurs en colonne.

Bien entendu, la capacité de l'élément photosensible peut être diminuée en diminuant sa surface active, mais une telle disposition va à l'encontre d'une autre exigence qui est que, pour capter le maximum de lumière, issue par exemple d'un écran scintillateur placé en contact ou à proximité de l'un des réseaux d'électrodes ou conducteurs en ligne ou en colonne, il est nécessaire que l'élément photosensible présente la surface active maximale possible avec les pas des réseaux de conducteurs en ligne et de conducteurs en colonne. Les pas des réseaux de conducteurs ligne et de conducteurs colonne partagent la surface de la matrice en une pluralité de surfaces élémentaires ayant chacune un point photosensible, chaque surface élémentaire étant éclairée par la lumière provenant d'une partie correspondante du scintillateur, partie qui elle-même représente une surface d'image élémentaire.

Avec la présente invention, l'un des buts visés est d'améliorer le rapport signal/bruit, en diminuant la capacité présentée par chacun des points photosensibles, dans un détecteur d'images associant un écran ou panneau formant notamment scintillateur, et une matrice d'éléments photosensibles. Ce but est atteint par un agencement nouveau, particulièrement au niveau du panneau, qui permet de réduire beaucoup plus la surface active d'un élément photosensible, que la quantité de lumière à laquelle cet élément photosensible est exposé. L'invention concerne donc particulièrement un tel panneau associé ou non à une matrice photosensible.

Selon l'invention, un détecteur d'images comportant, un écran scintillateur exposé à un rayonnement incident, une matrice de points photosensibles, la matrice comportant des conducteurs en ligne et des conducteurs en colonne orthogonaux, la matrice étant partagée en surfaces élémentaires ayant chacune un point photosensible, le scintillateur émettant un rayonnement de lumière en réponse au rayonnement incident, est caractérisé en ce qu'un écran de sortie est interposé entre le scintillateur et les surfaces élémentaires, l'écran de sortie étant opaque et peu absorbant vis-à-vis de la lumière émise par le scintillateur, l'écran de sortie étant perforé de sorte à comporter, au regard de chaque point photosensible, au moins une ouverture laissant passer la lumière du scintillateur, et en ce que l'ouverture a une surface inférieure à celle d'une surface élémentaire.

L'invention sera mieux comprise grâce à la description qui suit, faite à titre d'exemple non limitatif, et à l'aide des quatre figures annexées parmi lesquelles :

- la figure 1 montre, à titre d'exemple non limitatif, le schéma électrique d'une matrice photosensible susceptible d'être utilisée dans un détecteur d'images conforme à l'invention ;

- la Figure 2 montre de manière schématique un détecteur d'images selon l'invention, et illustre son principe de fonctionnement ;

- les figures 3a et 3b sont des coupes latérales selon deux directions orthogonales, montrant schématiquement une première réalisation d'un détecteur d'image selon l'invention ;

- la figure 4 est une vue en coupe latérale, qui illustre schématiquement une seconde réalisation du détecteur d'image de l'invention.

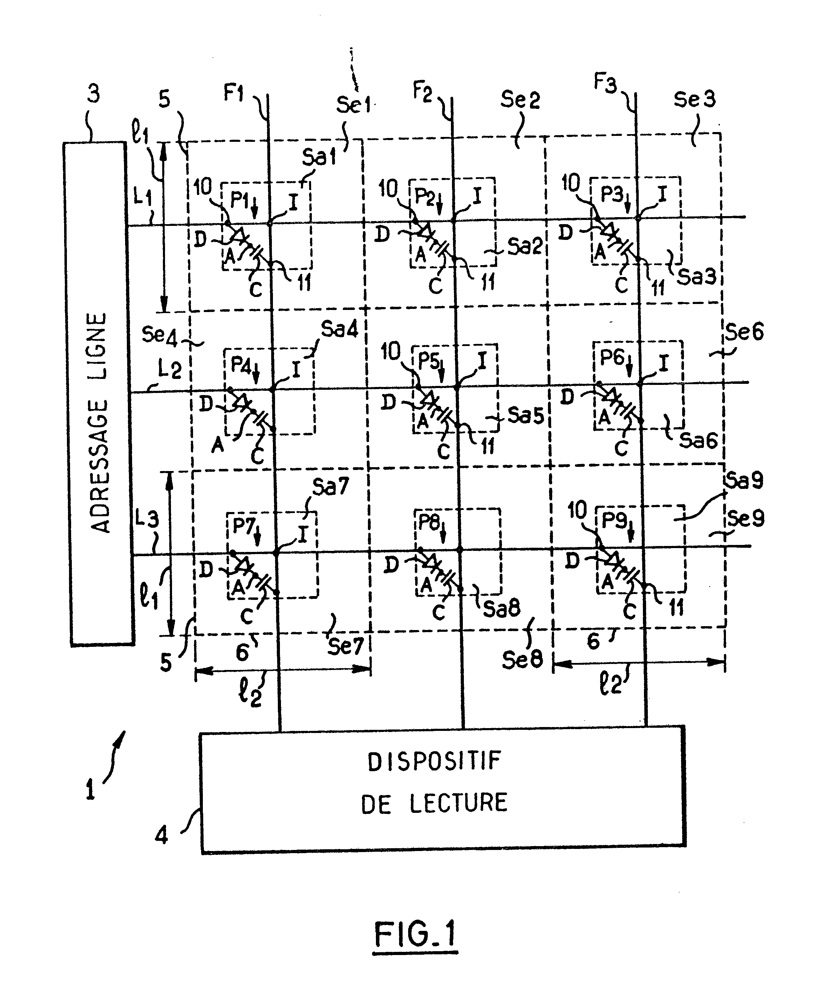

La figure 1 montre le schéma électrique d'une matrice photosensible 1, ce schéma électrique étant en lui-même classique. En effet la matrice 1 comprend une pluralité de points photosensibles P1, P2, ..., P9 qui sont disposés en ligne et en colonne, et qui sont constitués chacun, dans l'exemple non limitatif décrit, par un élément photosensible D en série avec une capacité C selon un même montage que les points photosensibles décrits dans les brevets français n° 86 00656 et n° 86 00716 précédemment cités ; bien entendu l'invention est applicable avec d'autres types de cellules photosensibles. Dans l'exemple non limitatif décrit, le nombre de points photosensibles P1 à P9 est limité à 9 selon un assemblage matriciel 3 x 3 pour simplifier la figure 1, mais dans l'esprit de l'invention cet assemblage matriciel peut avoir une capacité beaucoup plus grande, de plusieurs millions de points par exemple comme il a été précédemment mentionné.

La matrice 1 comporte des conducteurs en ligne L1 à L3 et des conducteurs en colonne F1 à F3, le nombre de chaque type de ces conducteurs étant limité à 3 compte-tenu de l'exemple de la figure 1 où seulement 9 points photosensibles sont représentés.

En pratique et d'une manière en elle-même classique, les points photosensibles P1 à P9 sont formés chacun à l'intersection d'un conducteur en lignes L1 à L3 et d'un conducteur en colonne F1 à F3. Chaque point photosensible P1 à P9 comporte une première extrémité 10 connectée à un conducteur ligne L1 à L3, et comporte une seconde extrémité 11 connectée à un conducteur colonne F1 à F3. La jonction formée entre l'élément photosensible D et la capacité C constitue une zône A où sont engendrées et stockées des charges dont la quantité est proportionnelle à l'éclairement de l'élément photosensible. Dans l'exemple non limitatif décrit, l'élément photosensible D est une photodiode, mais il pourrait être d'un type différent, être un phototransistor notamment d'un type NIPIN ou PINIP.

Les conducteurs en ligne L1 à L3 sont reliés à un dispositif d'adressage ligne 3, et les conducteurs en colonne F1 à F3 sont reliés à un dispositif de lecture et de multiplexage 4, de sorte à mettre en oeuvre l'un ou l'autre des procédés enseignés dans les demandes de brevet français n° 86 00656 et n° 86 00716, en vue dans un premier temps, de permettre la création et le stockage de charges ou d'informations aux différents points A, et dans un second temps de permettre la lecture et l'acquisition de ces informations. On rappelle que pour chaque point photosensible P1 à P9, les phases principales du fonctionnement sont les suivantes :

- (1) phase de polarisation en inverse de la photodiode ;
- (2) phase d'éclairement de la photodiode (par suite par exemple d'un flash d'un rayonnement X pour l'irradiation d'un patient, et conversion du rayonnement X en un rayonnement de longueur visible ou proche du visible) ; stockage de l'information correspondant à l'éclairement ;
- (3) phase de lecture (polarisation en direct de la photodiode) ;
- (4) phase de remise à niveau des tensions aux bornes de la photodiode, obtenue soit à l'aide d'une impulsion électrique de polarisation appliquée aux conducteurs ligne, soit au moyen d'un éclairement uniforme calibré, soit au moyen d'un flash lumineux intense.

Comme il a été mentionné dans le préambule, la matrice 1 est partagée en surfaces élémentaires Se1, Se2, ..., Se9, centrées chacune sur un centre de croisement ou intersection I entre un conducteur en ligne L1 à L3 et un conducteur colonne F1 à F3, et comportant chacune un point photosensible P1 à P9. Les surfaces élémentaires Se1 à Se9 ont des dimensions déterminées par les pas des réseaux de conducteurs en ligne et en colonne L1 à L3 et F1 à F3. lesquels pas sont symbolisés respectivement par une première et seconde longueur l1, l2 d'un premier et d'un second côté 5, 6 des surfaces élémentaires Se1 à Se9. Si les pas sont les mêmes, les surfaces élémentaires Se1 à Se9 ont une forme carrée, comme dans l'exemple non limitatif décrit. Ainsi,dans le cas de matrice à grande capacité (plusieurs millions de points), la longueur l1, l2 d'un côté 5, 6 peut être 200 micromètres.

Dans l'art antérieur, la configuration classique consiste à conférer aux points photosensibles une surface active (formée par la surface d'un élément photosensible) aussi grande que possible, pour capter le maximum de lumière issue par exemple d'un écran scintillateur (non représenté sur la Figure 1) : l'écran scintillateur étant par exemple dans un plan parallèle à celui de la figure, il est exposé à des rayons X (non représentés) dont la direction moyenne est perpendiculaire au plan de la figure, et l'écran scintillateur émet en réponse aux rayons X des rayons lumineux qui sont absorbés par les éléments photosensibles. Aussi dans le cas le plus courant de l'art antérieur, la surface active des points photosensibles tend à avoir une même surface que les surfaces élémentaires, un peu inférieure bien entendu pour éviter des courts-circuits entre des points photosensibles adjacents, de sorte que chaque élément photosensible à une capacité propre importante

Avec la présente invention, au contraire, les points photosensibles P1 à P9 peuvent avoir une surface active Sa1, Sa2, ..., Sa9 très inférieure aux surfaces élémentaires Se1 à Se9, sans nuire à la sensibilité, de sorte à augmenter le rapport Signal/Bruit. Dans l'exemple non limitatif montré à la figure 1, les surfaces actives Sa1 à Sa9 sont représentées centrées sur une intersection I, mais dans l'esprit de l'invention ces surfaces actives et par conséquent les éléments photosensibles D peuvent ne pas être disposés centrés sur ces intersections.

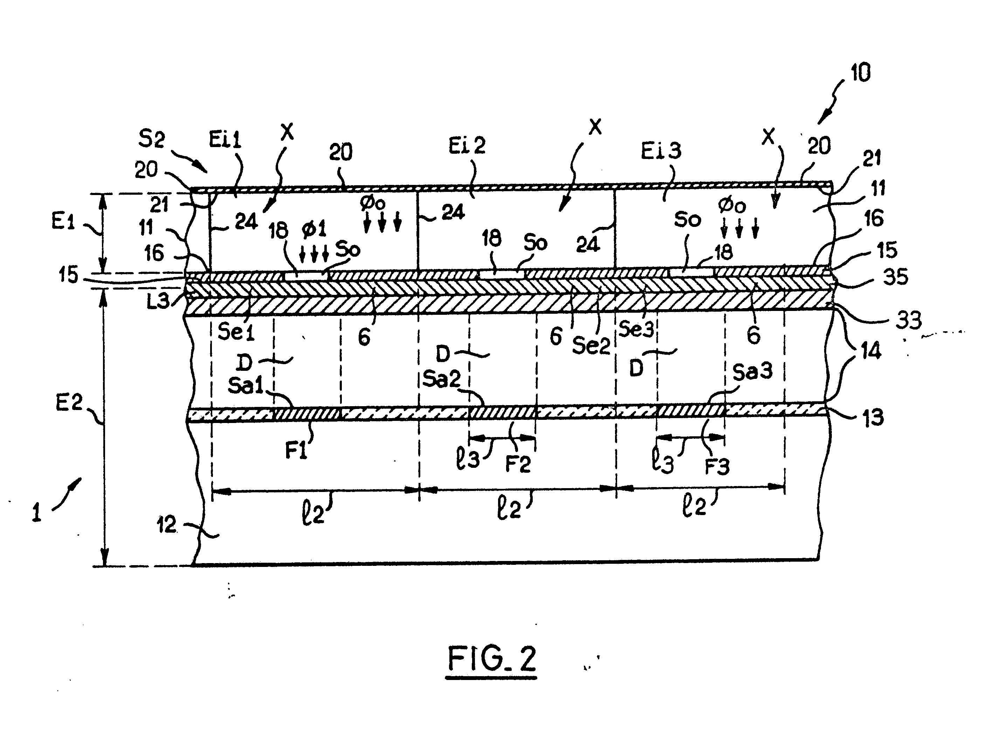

La figure 2 montre schématiquement, à titre d'exemple non limitatif, un dispositif détecteur d'images 10 conforme à l'invention.

Le détecteur d'images 10 utilise un écran scintillateur 11 et une structure de matrice photosensible 1 dont le schéma électrique est par exemple celui représenté à la Figure 1. L'écran scintillateur 11 et la matrice photosensible 1 sont disposés l'un au-dessus de l'autre dans des plans perpendiculaires à celui de la figure 2, et sont vus par leur épaisseur respectivement E1, E2.

En supposant que l'écran scintillateur 11 soit destiné à convertir un rayonnement x incident en photon lumineux visibles, il peut avoir une épaisseur E1 de l'ordre de 100 à 400 micromètres par exemple, et être constitué de matériaux classiques tels que couramment utilisés pour la fabrication des écrans radiologiques, à savoir tungstate de calcium, oxysulfure de gadolinimum, halogénure d'alcalin tel que iodure de cesium, etc...

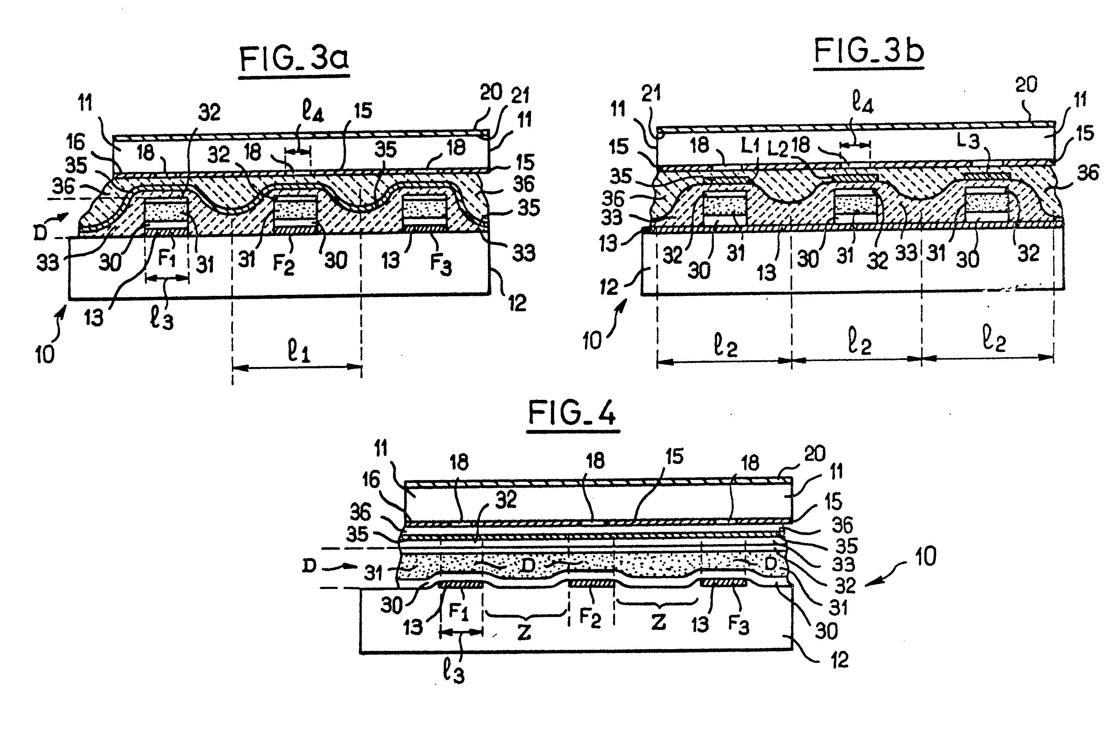

La matrice photosensible 1 est formée par une structure qui est davantage expliquée dans une suite de la description faite en référence aux figures 3a ,3b. Cette structure est obtenue par les dépôts successifs, sur un substrat 12, d'une première couche électriquement conductrice 13, suivie d'un empilement 14 de plusieurs couches semiconductrices, empilement sur lequel est déposée une couche diélectrique 33 transparente à la lumière. Par dessus la couche diélectrique 33 est déposée une couche 35 électriquement conductrice destinée à constituer un réseau d'électrodes, un réseau de conducteurs en ligne L1 à L3 par exemple ; l'ensemble étant recouvert de l'écran scintillateur 11. Dans l'exemple non limitatif décrit, la première couche conductrice 13 située vers le substrat 12, est gravée de sorte à constituer les électrodes en colonne ou conducteurs en colonne F1, F2, F3 qui s'étendent dans un plan perpendiculaire à celui de la figure, et la couche conductrice 35 supérieure située vers le scintillateur 11 est également gravée pour constituer des électrodes ligne ou conducteurs en ligne L1, L2, L3 qui s'étendent parallèlement au plan de la figure 2 et dont seul un unique conducteur en ligne L3 par exemple apparaît sur la figure 2.

Comme il a été précédemment mentionné, la surface de la matrice 1 est partagée en surfaces élémentaires Se1 à Se9 qui apparaissent, sur la figure 2, par la longueur l2 de leur côté 6 parallèle aux conducteurs en ligne L1 à L3. La surface S2 de l'écran scintillateur 11 peut également être considérée comme partagée en images élémentaires Ei1, Ei2, ..., Ei9 situées en vis-à-vis des surfaces élémentaires Se1 à Se9 et ayant une même surface que ces dernières.

Le scintillateur 11 étant exposé à des rayons x, il assure localement dans chacun des volumes correspondant à une image élémentaire Ei1, à Ei9, la conversion du rayonnement X incident en photons lumineux φ o visibles (non représentés) qui sont émis vers la surface élémentaire Se1 à Se9 correspondante.

Selon une caractéristique de l'invention, un écran de sortie 15 opaque à la lumière émise par le scintillateur 11 est disposé entre ce dernier et la matrice 1 ; plus précisément l'écran de sortie 15 est appliqué sur le scintillateur 11 contre une face de sortie 16 de ce dernier, orientée vers la matrice 1. L'écran de sortie 15 comporte, au regard de chaque surface élémentaire Se1 à Se9, au moins une ouverture ou trou 18, ces ouvertures 18 permettant le passage de la lumière émise par le scintillateur vers les surfaces élémentaires Se1 à Se9, c'est-à-dire vers les éléments photosensibles. La fonction de l'écran de sortie 15 est de renvoyer vers l'intérieur du scintillateur 11, et donc d'absorber le moins possible, les photons qui sont orientés pour sortir du scintillateur par la face de sortie 16 de ce dernier, en dehors des zônes de passage prévues que constituent les ouvertures 18. Le scintillateur 11 comporte en outre un second écran 20 disposé sur une face d'entrée 21 opposée à la face de sortie 16, et dont la fonction est de réfléchir ou diffuser les photons vers la face de sortie 16.

Dans cette configuration, bien que les ouvertures ou orifices de sortie 18 aient une surface So très inférieure à la surface d'un élément d'images Ei1 à Ei9, surface par laquelle sortirait du scintillateur 11 le flux de photons φ 0 si le premier écran ou écran de sortie 15 était absent, il est constaté que le flux de photons φ 1 sortant par un orifice 18 peut être du même ordre de grandeur que le flux φ 0 qui existerait en l'absence du premier écran 15. Nous pensons que cet effet, étonnant à première vue, peut s'expliquer par le fait que les photons qui rencontrent l'écran de sortie 15 subissent de multiples réflexions et diffusions jusqu'à être sur une trajectoire qui passe par l'orifice de sortie 18. Le flux (non représenté) émis latéralement, c'est-à-dire parallèlement aux faces d'entrée et de sortie 21,16 du scintillateur 11, est compensé par un flux équivalent en provenance des éléments d'images Ei1 à Ei9 contigus. En fait, chaque élément d'image Ei peut être considéré comme possédant cinq parois dont l'une est constituée par le second écran ou écran d'entrée 20, les quatre autres parois étant constituées par les zônes frontières partagées avec les éléments d'images Ei voisins ; de telles parois 24 séparant des éléments d'images Ei contigus dans des plans perpendiculaires à celui de la figure 2, sont représentées sur cette dernière.

L'écran de sortie 15 ainsi que l'écran d'entrée 21 peuvent être réalisés en un métal à coefficient de réflexion élevé pour la lumière émise par le scintillateur, l'aluminium par exemple ou du chrome, ou encore par un matériau diffusant , d'albédo élevé , comme la magnésie par exemple.

Ainsi, aussi bien pour le premier écran 15 ou écran de sortie que pour le second écran 20 ou écran d'entrée, nous entendons définir par le terme écran opaque , un écran opaque à la lumière engendrée dans le scintillateur et n'absorbant pas ou peu cette lumière de sorte à la renvoyer dans le scintillateur par réflexion ou diffusion, c'est-à-dire un écran opaque d'albédo élevé.

La présence de l'écran de sortie 15 perforé et de l'écran d'entrée 20 tend à créer dans le scintillateur 11, l'équivalent d'un réseau matriciel de concentrateurs optiques de l'énergie lumineuse (de l'énergie lumineuse créée au sein du scintillateur), ces concentrateurs optiques étant formés par des cavités ou pseudocavités d'efficacité optique élevée formées au regard de chaque élément d'image Ei1 à Ei9 et, par conséquent indexées sur le réseau de surface élémentaire Se1 à Se9 de la matrice 1 et particulièrement des éléments photosensibles.

La surface So des orifices de sortie 18 est très inférieure à celle des éléments d'images Ei1 à Ei9 et aux surfaces élémentaires Se1 à Se9, de sorte qu'il suffit que la surface active Sa1 à Sa9 d'un élément photosensible soit égale ou un peu supérieure à la surface So d'un orifice de sortie 18 pour capter toute la lumière émise par un élément d'image EI du scintillateur 11.

Dans l'exemple non limitatif représenté à la figure 2, les diodes photosensibles D sont formées dans l'empilement 14 de couches semiconductrices et sont délimitées par la surface d'intersection entre les conducteurs en colonne F1 à F3 et les conducteurs en ligne L1 à L3 (dont seulement le troisième conducteur L3 est visible selon sa longueur sur la figure 2). Cette surface d'intersection forme la surface active Sa des éléments photosensibles D et elle est représentée sur la figure 2 par une largeur l3 des conducteurs colonne F1 à F3. Si les conducteurs en ligne L1 à L3 ont une même largeur (non visible sur la figure 2) que la largeur l3 des conducteurs en colonne F1 à F3, la surface active Sa d'un élément photosensible a une forme carrée dont le côté, c'est-à-dire la largeur l3 d'un conducteur colonne peut être par exemple comprise entre 20 et 50 micromètres, et définir ainsi des éléments photosensibles D ayant une surface active Sa1 à Sa9 très inférieures aux surfaces élémentaires Se1 à Se9.

Dans l'art antérieur, pour capter le maximum de lumière, la surface active d'un élément photosensible est égale ou un peu inférieure à la surface élémentaire Se1 à Se9, c'est-à-dire de l'ordre de 40.000 micromètres$^2$ si le côté d'une surface élémentaire Se1 à Se9 à une longueur l1, l2 de 200 micromètres. Dans le détecteur d'image conforme à l'invention, un élément photosensible D dont la surface active Sa1 à Sa9 à un côté correspondant à la largeur l3 de par exemple 50 micromètres, capte le maximum de lumière avec une surface active Sa1 à Sa9 au moins quinze fois plus petite que dans l'art antérieur, d'où il résulte que dans ce cas, dans le détecteur d'images de l'invention, un élément photosensible D présente une capacité au moins quinze fois plus faible que dans l'art antérieur. Il est à noter que ceci constitue une amélioration considérable, car une amélioration déjà très satisfaisante serait obtenue si la surface active Sa était par exemple moitié de la surface élémentaire Se. On remarque qu'une structure où l'élément photosensible D a une surface active Sa faible par rapport à la surface élémentaire Se, non seulement réduit la capacité, mais réduit également le courant d'obscurité qui peut être considéré comme un bruit perturbateur.

Il est à noter que dans l'exemple non limitatif représenté à la figure 2, le scintillateur 11 est pratiquement au contact ou à proximité immédiate de la matrice 1. Mais, dans l'esprit de l'invention, les scintillateur 11 peut également être à proximité non immédiate de la matrice d'élément photosensible 1, la lumière sortant des orifices de sortie 18 peut alors être transférée par des conduits de lumière formant des fibres optiques en elle-mêmes classiques, en verre par exemple ou en plastique, présentant une faible absorption, non dégrandisseurs, et à rendement de transfert optique voisin de l'unité.

Il est à noter en outre que, d'une part, un scintillateur formé par un panneau ayant un même agencement que le scintillateur 11 de sorte à constituer l'équivalent d'un réseau matriciel de concentrateurs optiques, comme il a été ci-dessus expliqué, peut être utilisé avantageusement sans être associé à une matrice photosensible comme dans l'exemple ci-dessus ; d'autre part, un tel agencement peut s'appliquer également à un panneau ou écran non constitué par une substance scintillatrice :

a) un panneau scintillateur ainsi agencé, exposé au rayonnement incident (rayons X par exemple), peut être observé à l'oeil directement. Le flux lumineux sortant d'une pseudo cavité étant du même ordre que le flux lumineux émis dans le panneau en l'absence de l'écran de sortie 15 perforé ; il en résulte une luminance locale plus importante (à flux égal, les luminances sont dans le rapport de la surface d'image élémentaire EI à la surface So de l'orifice de sortie 18)

b) le panneau peut être couplé, par contact optique, à un film photographique, tel que par exemple couramment exploité en radiographie. Ce film pouvant présenter une caractéristique de noircissement non linéaire (gamma 1 à 4) , il peut en résulter un noircissement (local, à l'endroit des orifices de sortie 18) plus important qu'avec un panneau ou écran scintillateur classique. Il en résulte un gain important de dose de rayonnement pour effectuer la radiographie. Il peut être nécessaire d'observer le film après développement au travers d'un masque opaque perforé selon une distribution identique à celle des orifices de sortie 18 ;

c) le panneau ou écran peut être du type dit " à projection par la face arrière", utilisé en télévision. Dans ce cas, le panneau n'est pas constitué de matériau fluorescent sous l'excitation d'un rayonnement X, mais il est constitué de matériau transparent ou faiblement diffusant pour la lumière projetée sur la face opposée à celle qui est observée ; ce panneau comportant alors seulement l'écran de sortie 15 perforé.

Les Figures 3a et 3b sont des coupes latérales selon deux directions orthogonales, qui montrent, à titre d'exemple non limitatif, et de manière schématique, une première forme de réalisation d'un détecteur d'images conforme à l'invention.

Le détecteur d'images comporte le substrat 12 en verre par exemple transparent ou non. Une couche 13 d'un matériau électriquement conducteur est déposée sur le substrat 12. Cette couche 13 de matériau électriquement conducteur est constituée par exemple par de l'oxyde d'indium-étain (ITO) ; cette couche 13 étant gravée de sorte à constituer les conducteurs en colonne F1, F2, F3 au pas de 200 micromètres par exemple et ayant une largeur l3 de 50 micromètres par exemple. On trouve ensuite les éléments photosensibles D, chaque élément photosensible étant constitué par exemple par une diode PIN (jonction PN avec partie centrale intrinsèque). Les diodes D sont formées par le dépôt sur les conducteurs de colonne, de trois couches successives 30, 31, 32.

La première couche 30 est une couche de silicium amorphe hydrogéné dopé avec une impureté de type P, du bore par exemple; la seconde couche 31 est une couche de silicium amorphe hydrogéné intrinsèque ; la troisième couche 32 est une couche de silicium amorphe hydrogéné dopé avec une impureté de type N, de phosphore par exemple. Ces trois dernières couches 30,31,32 sont gravées selon un motif d'îlots de manière à constituer les éléments photosensibles ou diodes D ; les îlots ayant une forme carrée dont les côtés ont une même dimension que la largeur l3 des conducteurs colonne F1 à F3, cette largeur l3 des conducteurs colonne étant elle-même très inférieure à la dimension l1 d'un côté d'une surface élémentaire SE1 à SE9. Au-dessus de cette troisième couche 32 appartenant aux photodiodes D, on trouve une couche isolante 33, destinée à former le diélectrique des capacités C (montrées sur la Figure 1) qui sont en série avec les éléments photosensibles D ; la couche 33 diélectrique étant transparente, constituée par exemple en nitrure de silicium.

La couche diélectrique 33 est recouverte par une couche conductrice supérieure 35 transparente également (constituée par exemple en oxyde d'indium-étain), et qui est gravée pour former les conducteurs en ligne L1 à L3. Dans l'exemple non limitatif de la description, les conducteurs en ligne L1 à L3 ont une même largeur que les conducteurs en colonne F1 à F3.

Au-dessus de la couche conductrice supérieure 35 à partir de laquelle sont formés les conducteurs en ligne, est placée une couche 11 d'une substance scintillatrice, de l'oxysulfure de gadolinium par exemple qui émet une lumière visible en réponse à un rayonnement X incident. Ainsi par exemple, la couche scintillatrice 11 peut être constituée par une poudre d'oxysulfure de gadolinium noyée dans une résine thermodurcissable, de manière à constituer une feuille, cette feuille ayant une épaisseur comprise entre 100 et 400 micromètres.

Comme il a été expliqué en référence à la Figure 2, la couche scintillatrice ou scintillateur 11 a une face de sortie 16 contre laquelle est appliqué l'écran de sortie 15 ayant des orifices de sortie 18. A cette fin, dans l'exemple non limitatif de la description, une couche transparente 36 d'un matériau isolant est déposée sur les conducteurs en ligne L1 à L3, en vue notamment de constituer au-dessus de ces derniers une couche isolante et former une surface sensiblement plane 37. L'écran de sortie 15 est constitué par exemple par une couche d'aluminium déposée sur la surface plane 37. La couche 15 d'aluminium est ensuite gravée de sorte à constituer les orifices de sortie 18 ayant par exemple une section carrée dont les côtés ont une longueur l4 (de 40 microns par exemple) égale ou inférieure à la largeur l3 des conducteurs en colonne et des conducteurs en ligne F1 à F3 et L1 à L3. La feuille formant le scintillateur 11 est collée sur l'écran de sortie 15. Bien entendu la couche d'aluminium destinée à former cet écran de sortie 15, peut également être déposée directement sur la face de sortie 16 du scintillateur 11. L'écran d'entrée ou second écran 20 est par exemple également constitué en aluminium, selon une couche qui est déposée sur la face d'entrée 21 du scintillateur 11.

Le mode de réalisation représenté aux Figures 3a, 3b est donné à titre d'exemple non limitatif, et notamment les couches 30, 31, 32, 33 avec lesquelles sont constituées les photodiodes D et les capacités C, peuvent être disposées dans des ordres différents, de sorte à constituer par exemple aussi bien des photodiodes de type PIN que NIP, ou de sorte à modifier les positions entre la photodiode et la capacité par rapport aux connecteurs en ligne et en colonne. Les éléments photosensibles peuvent également être de nature différente, des phototransistors par exemple, l'essentiel étant de concentrer le flux de photons au niveau de chaque élément photosensible, à l'aide d'un réflecteur perforé selon le principe de l'écran de sortie 15, de sorte à permettre une réduction de la surface active Sa des éléments photosensibles D et par suite diminuer la capacité présentée par chacun de ces éléments photosensibles.

La Figure 4 illustre une seconde version du détecteur d'images conforme à l'invention dans laquelle les trois couches semiconductrices 30, 31, 32 à partir desquelles sont constituées les photodiodes D, ne sont pas gravées.

En effet dans l'exemple décrit en référence aux figures 3a et 3b, les couches 30,31, 32 de silicium sont gravées selon des formes d'îlots, par gravure chimique par exemple ou par gravure sèche sous plasma, cette opération de gravure constituant une opération d'un coût non négligeable.

La réalisation montrée à la Figure 4 est analogue à celle de la Figure 3a, à l'exception du fait que l'opération de gravure des îlots de silicium amorphe après dépôt des trois couches successives 30,31,32, n'est pas effectuée.

En fonctionnement, par suite de la mise sous tension des conducteurs en ligne et des conducteurs en colonne L1 à L3 et F1 à F3, un champ électrique (non représenté) est créé entre chacun de ces types de conducteurs selon un surface qui correspond à la surface de leur intersection, et en dehors de cette surface (représentée sur la figure 4 par la largeur l3 des conducteurs en colonne F1 à F3) les couches semiconductrices 30, 31, 32 sont soumises à un champ électrique négligeable. Ainsi il existe, entre des photodiodes D adjacentes des zones Z qui ne sont pas soumises à un champ électrique notable.

Par suite, ces zônes Z présentent une résistance très élevée évitant toute fuite électrique entre chaque photodiode ; cette propriété étant due aux nombreux pièges existant dans le matériau semiconducteur photosensible utilisé, le silicium amorphe notamment, qui en l'absence de champ électrique notable entraîne une très faible mobilité des porteurs électriques, et par suite une absence de conductivité. Il est à remarquer que le matériau semiconducteur photosensible susceptible d'être utilisé n'est pas uniquement du silicium amorphe hydrogéné, d'autres matériaux peuvent être utilisés tels que notamment le sélénium, l'oxyde de plomb déposé sous forme amorphe ou polycristalline, etc. Il est à noter que ces matériaux sont utilisés pour réaliser les couches photosensibles de type PIN de tubes de télévision, sous des épaisseurs comparables à celles qui sont ici utilisées, c'est-à-dire de l'ordre de 0,5 à quelques micromètres.

Il est à noter en outre que dans la description, on a supposé que l'invention s'appliquait à la détection d'images de rayons X, notamment en radiologie médicale, mais elle s'applique aussi à détecter d'autres radiations, pourvu qu'on dispose de substances scintillatrices effectuant les conversions de longueur d'onde désirée.

## Revendications

1/ Détecteur d'images comportant, un scintillateur (11) exposé à un rayonnement incident, une matrice (1) de points photosensibles (P1 à P9), la matrice (1) comportant des conducteurs en ligne (L1 à L3) et des conducteurs en colonne (F1 à F3) orthogonaux, la matrice (1) étant partagée en surfaces élémentaires (Se1, Se2, ..., Se9) ayant chacune un point photosensible (P1 à P9), le scintillateur (11) émettant un rayonnement de lumière en réponse au rayonnement incident, caractérisé en ce qu'un écran de sortie (15) est interposé entre le scintillateur (11) et les surfaces élémentaires (SE1 à SE9), l'écran de sortie (15) étant opaque et peu absorbant vis-à-vis de la lumière émise par le scintillateur (11), l'écran de sortie (15) étant perforé de sorte à comporter, au regard de chaque point photosensible (P1 à P9), au moins une ouverture (18) laissant passer la lumière du scintillateur (11), et en ce que l'ouverture (18) a une surface (So) largement inférieure à celle d'une surface élémentaire (SE1 à SE9), et en ce qu'un second écran (20) non perforé est disposé sur une face d'entrée (21) du scintillateur (11) opposée aux surfaces élémentaires (Se1 à Se9), le second écran (20) étant opaque et peu absorbant vis-à-vis de la lumière émise par le scintillateur (11).

2/ Détecteur d'images selon la revendication 1, caractérisé en ce que les points photosensibles (P1 à P9) ont une surface active (Sa) largement inférieure à une surface élémentaire (Se1 à Se9).

3/ Détecteur d'images selon l'une des revendications précédentes, caractérisé en ce que les points photosensibles (P1 à P9) ont une surface active (Sa) égale ou inférieure à la moitié d'une surface élémentaire (Se1 à Se9).

4/ Détecteur d'images selon l'une des revendications précédentes, caractérisé en ce que les ouvertures (18) ont une surface (SO) égale ou inférieure à une surface active (Sa).

5/ Détecteur d'images selon l'une des revendications précédentes, caractérisé en ce que l'écran de sortie (15) est appliqué contre une face de sortie (16) du scintillateur (11) orientée vers les surfaces élémentaires (Se1 à Se9).

6/ Détecteur d'images selon l'une des revendications précédentes, caractérisé en ce que au moins un des deux écrans (15, 20) est réfléchissant.

7/ Détecteur d'images selon l'une des revendications précédentes, caractérisé en ce que au moins un des deux écrans (15, 20) est diffusant.

8/ Détecteur d'images selon l'une des revendications précédentes, les points photosensibles (P1 à P9) comportant au moins un élément photosensible (D), les éléments photosensibles (D) étant formés à partir d'un empilement (14) de couches semiconductrices (30, 31, 32) situées entre un plan contenant les conducteurs en ligne (L1 à L3) et un plan contenant les conducteurs en colonne (F1 à F3), caractérisé en ce que les conducteurs en ligne et en colonne (L1 à L3, F1 à F3) ont une largeur (l3) inférieure aux dimensions (l1, l2) d'une surface élémentaire (Se1 à Se9).

9/ Détecteur d'images selon la revendication 8, caractérisé en ce que les éléments photosensibles (D) sont délimités par gravure des couches semiconductrices (30, 31, 32).

10/ Détecteur d'images selon la revendication 9, caractérisé en ce que les éléments photosensibles (D) sont délimités sensiblement par une surface d'intersection (Sa) formée au croisement d'un conducteur en ligne (L1 à L3) et d'un conducteur en colonne (F1 à F3), les couches semiconductrices (30, 31, 32) n'étant pas gravées.

11/ Détecteur d'images selon l'une des revendications précédentes, caractérisé en ce que le rayonnement incident est un rayonnement X.

12/ Détecteur d'images comportant un panneau (11) exposé à un rayonnement incident, le panneau (11) comportant une face d'entrée (21) exposée au rayonnement incident et une face de sortie (16) par laquelle sort un rayonnement de lumière, caractérisé en ce que la face de sortie (16) comporte un écran de sortie (15) réfléchissant pour la lumière sortant du panneau (11), l'écran de sortie (15) étant perforé de sorte à comporter des ouvertures (18) disposées selon un arrangement matriciel, et en ce que la face d'entrée (21) comporte un écran d'entrée (20) réfléchissant pour la lumière sortant du panneau (11).

13/ Détecteur d'images selon la revendication 12, caractérisé en ce que le panneau (11) est constitué par au moins une substance scintillatrice.

14/ Détecteur d'images selon l'une des revendications 11 ou 12 ou 13, caractérisé en ce que le rayonnement incident est un rayonnement x.

FIG.1

EP 0 337 826 A1

FIG. 2

## FIG_3a

## FIG_3b

## FIG_4

EP 0 337 826 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| D,Y | FR-A-2 593 343  (THOMSON-CSF) <br> * page 9, ligne 17 - page 11, ligne 20; figures 5,6 * | 1,4,12 | G 01 T   1/00 <br> H 01 L  27/14 <br> H 01 L  31/10 |
| A | | 8,9,11, 13 | |
| Y | EP-A-0 068 456  (HONEYWELL) <br> * page 1, ligne 10 - page 5, ligne 24; page 6, ligne 12 - page 10, ligne 2; revendications 1-7; figures 1-3 * | 1,4,12 | |
| Y | US-A-4 560 882  (BARBARIC et al.) <br> * abrégé; colonne 1, ligne 5 - colonne 4, ligne 12; revendications 1-4,19,20; figures 1,9 * | 1,4,12 | |
| A | US-A-3 963 926  (BORRELLO) <br> * colonne 1, ligne 43 - colonne 2, ligne 2; colonne 3, ligne 15 - colonne 4, ligne 47; figures 2-10 * | 1,2,4, 12 | |
| A | PATENT ABSTRACTS OF JAPAN <br> vol. 9, no. 190 (P-378)(1913), 7 août 1985; & JP - A - 60 58574 (TOSHIBA) 04-04-1985 | 1,4,5, 11-14 | DOMAINES TECHNIQUES RECHERCHES (Int. Cl.4) <br><br> H 04 N   3/00 <br> H 01 L  27/00 <br> H 01 L  31/00 <br> G 01 T   1/00 |
| A | PATENT ABSTRACTS OF JAPAN <br> vol. 11, no. 260 (P-608)(2707), 22 août 1987; & JP - A - 62 63880 (HITACHI MEDICAL CORP.) 20-08-1987 | 1,4,5, 11-14 | |
| A | PATENT ABSTRACTS OF JAPAN <br> vol. 8, no. 72 (P-265)(1509), 4 avril 1984; & JP - A - 58 216 973 (TOKYO SHIBAURA) 16-12-1983 | 2,11,13 ,14 | |

-/-

Le présent rapport a été établi pour toutes les revendications

| Lieu de la recherche | Date d'achèvement de la recherche | Examinateur |
|---|---|---|
| BERLIN | 13-06-1989 | BEITNER M.J.J.B. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

**Office européen**
**des brevets**

## RAPPORT DE RECHERCHE EUROPEENNE

Numero de la demande

EP 89 40 0633

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | PATENT ABSTRACTS OF JAPAN vol. 6, no. 2, (P-96)(880), 8 janvier 1982; & JP - A - 56 128 475 (TOKYO SHIBAURA) 07-10-1981 --- | 2,11,13 | |
| A | PATENT ABSTRACTS OF JAPAN vol. 9, no. 167 (P-372)(1890), 12 juillet 1985; & JP - A - 60 42671 (TOSHIBA) 06-03-1985 --- | 1,2 | |
| A | PATENT ABSTRACTS OF JAPAN vol. 8, no. 286 (P-324)(1723), 27 décembre 1984; & JP - A - 59 150 358 (CANON) 28-08-1984 --- | 1,6,13, 14 | |
| A | PATENT ABSTRACTS OF JAPAN vol. 9, no. 232 (P-389)(1955), 18 septembre 1985; & JP - A - 60 86480 (TOSHIBA) 16-05-1985 --- | 1,6,13, 14 | |
| A | DE-A-3 141 755 (HITACHI MEDICAL CORP.) * page 7, ligne 6 - page 12, ligne 16; figure 1 * --- | 1,7,11, 13,14 | DOMAINES TECHNIQUES RECHERCHES (Int. Cl.4) |
| A | FR-A-2 468 999 (THOMSON CSF) * le document en entier * --- | 2,8,11, 13,14 | |
| A | GB-A-2 143 373 (PHILIPS) * page 1, lignes 5-119; page 2, lignes 91-123; figures 1,5,6 * --- | 1,2,8,9 ,11,13, 14 | |
| A | PATENT ABSTRACTS OF JAPAN vol. 8, no. 252 (P-314)(1689), 17 novembre 1984; & JP - A - 59 122 988 (SHIMAZU) 16-07-1984 --- -/- | 1,12-14 | |

Le présent rapport a été établi pour toutes les revendications

| Lieu de la recherche | Date d'achèvement de la recherche | Examinateur |
|---|---|---|
| BERLIN | 13-06-1989 | BEITNER M.J.J.B. |

Office européen
des brevets

Numero de la demande

EP 89 40 0633

# RAPPORT DE RECHERCHE EUROPEENNE

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | PATENT ABSTRACTS OF JAPAN vol. 10, no. 290 (P-503), 2 octobre 1986; & JP - A - 61 110 079 (TOSHIBA) 28-05-1986 ----- | 1,5-7, 11-14 | |

DOMAINES TECHNIQUES RECHERCHES (Int. Cl.4)

Le présent rapport a été établi pour toutes les revendications

| Lieu de la recherche | Date d'achèvement de la recherche | Examinateur |
|---|---|---|
| BERLIN | 13-06-1989 | BEITNER M.J.J.B. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................
& : membre de la même famille, document correspondant

EPO FORM 1503 03.82 (P0402)